# EUROPEAN PATENT APPLICATION

(11) **EP 3 067 936 A1**
(43) Date of publication of application: **14.09.2016**
(21) Application number: 14859500.2
(22) Date of filing: 20.10.2014
(51) Int. Cl.: H01L 31/0216, H01L 31/0236, H01L 31/0747

(54) **SOLAR CELL**

(30) Priority: 08.11.2013 JP 2013232410
(71) Applicant: Panasonic Intellectual Property Management Co., Ltd., Osaka-shi, Osaka 570-6207 (JP)
(72) Inventor: HIROSE, Koichi, Chuo-ku, Osaka-shi, Osaka 540-6207 (JP); MATSUBARA, Yoshihiro, Chuo-ku, Osaka-shi, Osaka 540-6207 (JP); KAWAMOTO, Kunihiro, Chuo-ku, Osaka-shi, Osaka 540-6207 (JP)
(74) Representative: Müller-Boré & Partner Patentanwälte PartG mbB
(86) International application number: PCT/JP2014/005294
(87) International publication number: WO 2015/068341

(57) **Abstract**

A solar cell (10) has: a crystal substrate (11) having n-type conductivity type as one conductivity type; an n-type semiconductor layer (12) that is formed on a light receiving surface, i.e., one main surface of the crystal substrate (11); and a p-type semiconductor layer (13) that is formed on a rear surface, i.e., one main surface of the crystal substrate (11). The n-type semiconductor layer (12) and the p-type semiconductor layer (13) cover a part of a side surface intersecting the main surfaces of the crystal substrate (11), the thickness of the n-type semiconductor layer on the side surface, said thickness being in the normal line direction of the n-type semiconductor layer, is less than the thickness of the n-type semiconductor layer (12) on the light receiving surface, said thickness being in the normal line direction of the n-type semiconductor layer, and the thickness of the p-type semiconductor layer (13) on the side surface, said thickness being in the normal line direction of the p-type semiconductor layer, is less than the thickness of the p-type semiconductor layer (13) on the rear surface, said thickness being in the normal line direction of the p-type semiconductor layer.

## Description

### TECHNICAL FIELD

The present disclosure relates to a solar cell.

### BACKGROUND ART

Patent Literature 1 discloses a structure in which the semiconductor layer on the front surface side is formed over almost the whole surface of a substrate, and the semiconductor layer on the rear surface side is formed in an area smaller than the area of the substrate, in order to reduce the degradation of properties of a photovoltaic element due to the semiconductor layers on the front and rear surfaces wrapping around the end surface.

Patent Literature 2 discloses that, when in a photovoltaic element, for example, an n-type semiconductor layer is formed on a first main surface of an n-substrate, and a p-type semiconductor layer is formed on a second main surface, an n-substrate-n-layer-p-layer rectifying junction or an n-substrate-p-layer-n-layer reverse junction is formed on the side surface and the peripheral ends of the n-substrate, depending on the formation sequence of the semiconductor layers differing from each other in conductivity type. As stated in Patent Literature 2, the formation performed so as to form the former n-substrate-n-layer-p-layer rectifying junction results in the provision of a rectifying junction over the whole area of the substrate, and avoids the occurrence of adverse effects such as the suppression of the carrier transfer due to reverse junction.

### CITATION LIST

### PATENT LITERATURE

PATENT LITERATURE 1: JP 2001-044461A
PATENTLITERATURE 2: JP11-251609A

### SUMMARY OF INVENTION

### TECHNICAL PROBLEM

In a solar cell, the side surface of a substrate is exposed to be in a state of being free from a protective film, unlike a light receiving surface or a rear surface. The wrapping around the side surface of the substrate by the semiconductor layer on the light receiving surface side or the semiconductor layer on the rear surface side covers the side surface of the substrate, but may cause degradation of the properties of the solar cell, as described in Patent Literature 1 and Patent Literature 2.

In other words, it is necessary to form a protective film on the side surface of a crystal substrate without causing degradation of the properties of the solar cell.

### SOLUTION TO PROBLEM

The solar cell of an aspect of the present disclosure is a solar cell including: a crystal substrate having one conductivity type; a first semiconductor layer having the one conductivity type, formed on one main surface of the crystal substrate; and a second semiconductor layer having another conductivity type, formed on another main surface of the crystal substrate, wherein the first semiconductor layer and the second semiconductor layer cover a part of a side surface intersecting the main surfaces of the crystal substrate; the thickness of the first semiconductor layer on the side surface, said thickness being in the normal line direction of the first semiconductor layer, is less than the thickness of the first semiconductor layer on the one main surface, said thickness being in the normal line direction of the first semiconductor layer; and the thickness of the second semiconductor layer on the side surface, said thickness being in the normal line direction of the second semiconductor layer, is less than the thickness of the second semiconductor layer on the other main surface, said thickness being in the normal line direction of the second semiconductor layer.

### ADVANTAGEOUS EFFECTS OF INVENTION

According to an aspect of the present disclosure, a protective film can be formed on the side surface of a crystal substrate without causing degradation of properties of a solar cell.

### BRIEF DESCRIPTION OF DRAWINGS

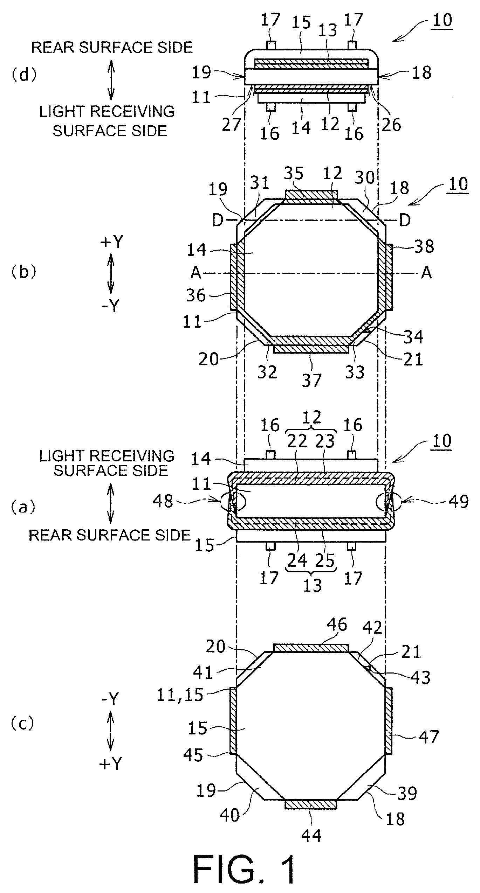

[FIG. 1] FIG. 1 is a diagram showing a solar cell in an embodiment; FIG. 1(a) is a sectional view, FIG. 1(b) is a plan view showing a light receiving surface side, FIG. 1(c) is a plan view showing the rear surface side, and FIG. 1(d) is a sectional view along the line D-D in FIG. 1(b), wherein the diagrammatic presentation of the current collecting electrodes is omitted in FIG. 1(b) and FIG. 1(c).

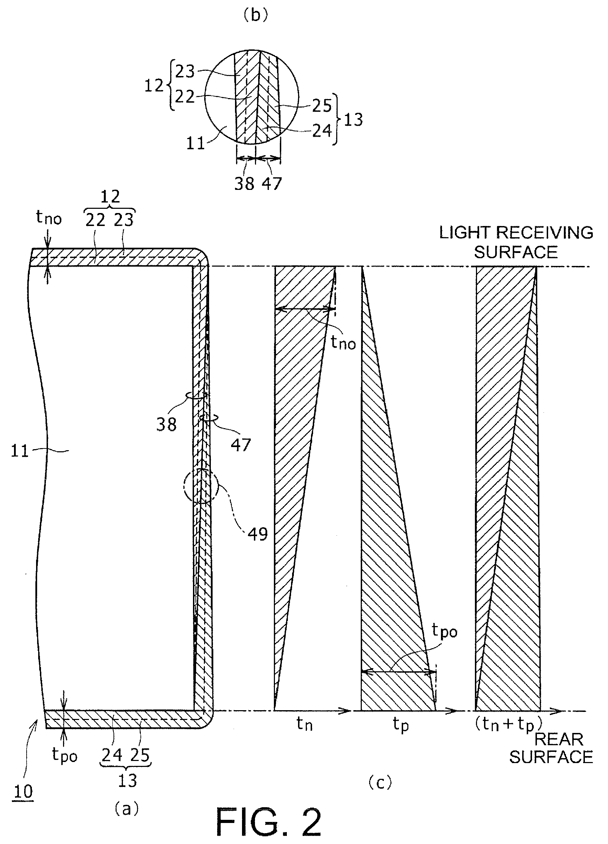

[FIG. 2] FIG. 2 is an enlarged view of the side surface in the solar cell in the embodiment; FIG. 2(a) is a sectional view, FIG. 2(b) is an enlarged view of a part of FIG. 2(a), and FIG. 2(c) is a diagram showing the film thickness distribution of the semiconductor layer in FIG. 2(a).

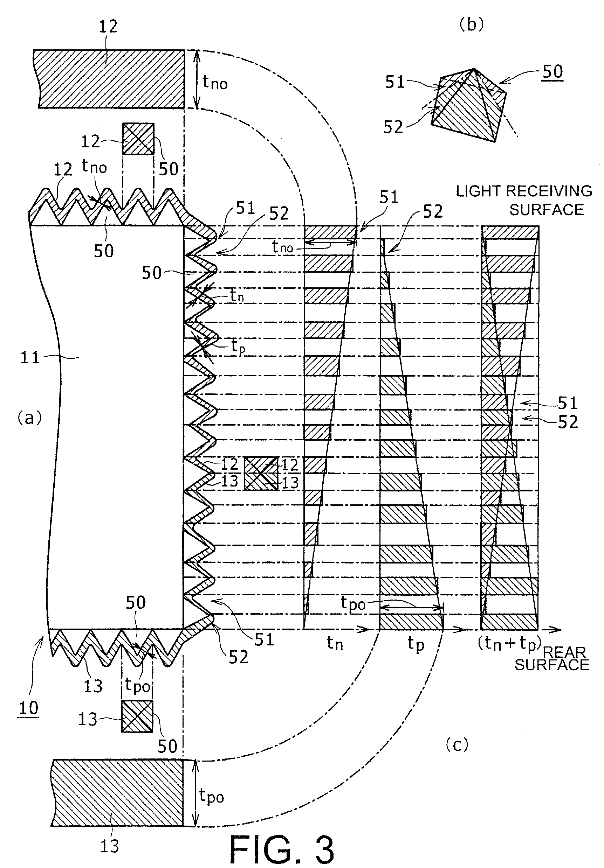

[FIG. 3] FIG. 3 is a view corresponding to FIG. 2, in the case where the solar cell has a texture structure in the crystal substrate in the solar cell of the embodiment; FIG. 3(a) is a sectional view, FIG. 3(b) is an enlarged view of the texture structure, and FIG. 3(c) is a diagram showing the film thickness distributions of the semiconductor layers in FIG. 3(a).

### DESCRIPTION OF EMBODIMENTS

Hereinafter, with reference to the accompanying drawings, an example of the embodiments is described in detail. The shapes, dimensions and material qualities described below are examples for illustration, and the shapes, dimensions and material qualities are not limited to these. The following drawings are schematic diagrams for illustration, and the scales of the lengths, widths and heights are sometimes different from the lengths, widths and heights of the actual solar cell and the like. Specific scales of the lengths, widths and heights are determined in consideration of the following descriptions.

FIG. 1 is a diagram showing a solar cell 10. The solar cell 10 is based on an experimentally verified finding that little leakage occurs in a case where an n-type amorphous semiconductor layer is allowed to wrap around the side surface of a crystal substrate from one main surface side, and a p-type amorphous semiconductor layer is allowed to wrap around the side surface of the crystal substrate from another main surface side solely so as to be overlapped on the n-type amorphous semiconductor layer. It is considered that, as described above, if no leakage occurs even when an n-type amorphous semiconductor layer on one main surface and a p-type amorphous semiconductor layer on another main surface are overlapped on each other on the side surface of a crystal substrate, the overlapped portions of these layers can be used as a protective film of the side surface. The following constitution is based on this finding.

FIG. 1(a) is a cross sectional view. In FIG. 1(a), an upper side is a light receiving surface side, and a lower side is a rear surface side. FIG. 1(b) is a plan view showing the light receiving surface side, FIG. 1(c) is a plan view showing the rear surface side, and FIG. 1(d) is a cross sectional view along the line D-D in FIG. 1(b). Note that FIG. 1(d) is illustrated in a layout direction opposite to FIG. 1(a), that is, the upper side is the rear surface side and the lower side is the light receiving surface side. Further, FIGs. 1(b) and 1(c) are illustrated to be inverse up and down, and an upper-lower direction for layout is defined as a Y direction, which is distinguished by signs with the upper side being +Y direction in FIG. 1(b) and -Y direction in FIG. 1 (c).

In this way, the cross sectional view varies depending on where to cut, and FIG. 1(a) corresponds to a cross sectional view along the line A-A in FIG. 1(b). Here, the "light receiving surface" refers to a surface in the solar cell 10 on which light is mainly incident from the outside. For example, more than 50% to 100% of the light incident on the solar cell 10 is incident from the light receiving surface side. Moreover, the "rear surface" refers to a surface opposite to the light receiving surface.

The solar cell 10 receives light such as sunlight, generates electrons and holes as carriers, collects the generated carriers, and collects and externally takes out a current from the collected carriers. A part generating the carriers is referred to as a photoelectric conversion part, which includes an n-type single-crystal silicon substrate 11, an n-type semiconductor layer 12, and a p-type semiconductor layer 13. Collection of the carriers is conducted by a transparent conductive film 14 on the light receiving surface side and a transparent conductive film 15 on the rear surface side. Current collection from the collected carriers is conducted by a current collecting electrode 16 on the light receiving surface side and a current collecting electrode 17 on the rear surface side. Hereinafter, the n-type single-crystal silicon substrate 11 is simply referred to as the crystal substrate 11.

The current collecting electrode 16 on the light receiving surface side is a current collecting electrode for carriers arranged on the transparent conductive film 14 on the light receiving surface side. The current collecting electrode 17 on the rear surface side is a current collecting electrode for carriers arranged on the transparent conductive film 15 on the rear surface side. These are each a thin wire-like electrode unit formed by screen-printing on the transparent conductive films 14 and 15 in a desired pattern, for example, a conductive paste having conductive particles of silver (Ag) or the like dispersed in a binder resin. Alternatively, instead of the screen-printing, various sputtering methods, various vapor-deposition methods, various plating methods and the like may be used to form the current collecting electrodes 16 and 17. As shown in FIGs. 1(a) and 1(d), a plurality of the respective current collecting electrodes 16 and 17 may be arranged.

The present disclosure relates to the structures of the photoelectric conversion part and the transparent conductive films 14 and 15, and thus the description of the current collecting electrodes 16 and 17 is left in the above description and a diagramatic representation thereof is shown only in FIGs. 1 (a) and 1(d). Hereinafter, the respective structures are described in detail.

The crystal substrate 11 including the photoelectric conversion part is a single crystal semiconductor substrate having one conductivity type. Here, one conductivity type is assumed to be n-type, and the single crystal semiconductor is assumed to be single-crystal silicon. A planar shape of the crystal substrate 11 has, as shown in FIGs. 1(b) and 1(c), an octagonal shape obtained by cutting out four corner portions 18, 19, 20, and 21 at an outer edge of a rectangular shape. An example of the size is described as follows: one side is from about 100 mm to about 200 mm, and each of the four corners is cut out by a length along a direction of the side from about 5 mm to about 16 mm. In a case of the solar cell 10 of thin type, a thickness is from about 75 µm to about 200 µm, for example. These sizes are examples, and may have other values.

The surfaces of the crystal substrate 11, namely, the light receiving surface, the rear surface, and the side surface, each have a texture structure. In each of FIGS. 1 and 2, the diagrammatic representation of the texture structure is omitted; in FIG. 3 presented below, the texture structure is described in detail. The "texture structure" as referred to herein means a uneven structure to suppress front surface reflection and increase the light absorption quantity of the photoelectric conversion section. The thickness of the crystal substrate 11 in the direction along which various films are laminated is a few tens to a few hundred microns, and the relief height of the texture structure is a few microns.

The n-type semiconductor layer 12 is a semiconductor layer of one conductivity type arranged on one main surface of the crystal substrate 11. If one main surface is the light receiving surface, one conductivity type is the conductivity type of the crystal substrate 11, therefore, the n-type semiconductor layer 12 is an n-type semiconductor layer arranged on the light receiving surface. The n-type semiconductor layer 12 includes an i-type amorphous silicon layer 22 and an n-type amorphous silicon layer 23 laminated on the layer 22.

The p-type semiconductor layer 13 is a semiconductor layer of the other conductivity type arranged on the other main surface of the crystal substrate 11. The other main surface, which is a main surface opposite to one main surface of the crystal substrate 11, is the rear surface of the crystal substrate 11 in the case of this embodiment. Additionally, one conductivity type is the conductivity type of the crystal substrate 11 and the other conductivity type is a conductivity type of other than the one conductivity type, and therefore a p-type semiconductor layer is arranged. The p-type semiconductor layer 13 includes an i-type amorphous silicon layer 24 and a p-type amorphous silicon layer 25 laminated on the layer 24. When the n-type semiconductor layer 12 and the p-type semiconductor layer 13 are distinguished from each other, the former is called a first semiconductor layer and the latter is called a second semiconductor layer.

In FIG. 1(a), the n-type amorphous silicon layer 23, the i-type amorphous silicon layer 22, the crystal substrate 11, the i-type amorphous silicon layer 24, and the p-type amorphous silicon layer 25 are laminated in this order from the light receiving surface side toward the rear surface side. When the i-type amorphous silicon layers 22 and 24 are distinguished, the former is called a first i-type amorphous silicon layer and the latter is called a second i-type amorphous silicon layer. A thickness of each of these laminated amorphous semiconductor thin films is from several nm to several tens of nm. For example, the thickness may be about 5 to about 20 nm.

The i-type amorphous silicon layers 22 and 24 are each an intrinsic amorphous silicon thin film which is lower in a concentration of a dopant generating the carriers than the n-type amorphous silicon layer 23 and p-type amorphous silicon layer 25. The first i-type amorphous silicon layer 22 and the second i-type amorphous silicon layer 24 may have the same composition. The n-type amorphous silicon layer 23 is an amorphous silicon thin film containing metal atoms of Group V at a predetermined concentration. Examples of the metal atoms of Group V include P (phosphorus). The p-type amorphous silicon layer 25 is an amorphous silicon thin film containing Group III metal atoms at a predetermined concentration. Examples of the Group III metal atoms include B (boron).

The photoelectric conversion section having the n-type semiconductor layer 12 on the light receiving surface side of the crystal substrate 11, and the p-type semiconductor layer 13 on the rear surface side of the crystal substrate 11, can be produced, as an example, by the following method.

First, the crystal substrate 11 is set in a vacuum chamber, and the i-type amorphous silicon layer 22 is laminated on the light receiving surface of the crystal substrate 11 by, for example, a plasma CVD (chemical vapor deposition) method. Successively, the n-type amorphous silicon layer 23 is laminated on the i-type amorphous silicon layer 22. Thus, the n-type semiconductor layer 12 is formed on the light receiving surface.

On the other hand, also on the rear surface of the crystal substrate 11, the i-type amorphous silicon layer 24 and the p-type amorphous silicon layer 25 are laminated in this order by, for example, the plasma CVD method. Thus, the p-type semiconductor layer 13 is formed on the rear surface. In place of the plasma CVD method, another reduced pressure CVD method may also be used. For example, a catalyst CVD method can be used.

In the step of laminating each of the i-type amorphous silicon layers 22 and 24, for example, silane gas (SiH₄) is used as a raw material gas. In the step of laminating the n-type amorphous silicon layer 23, silane (SiH₄), hydrogen (H₂), and phosphine (PH₃) are adopted as the raw material gases. In the step of laminating the p-type amorphous silicon layer 25, diborane (B₂H₆) is adopted as the raw material gas.

The n-type semiconductor layer 12 is formed on the whole light receiving surface of the crystal substrate 11, except for the areas corresponding to the four corner portions 18, 19, 20 and 21 of the outer edge of the crystal substrate 11. The crystal substrate 11 is held at a predetermined position in a plasma CVD apparatus in order to form the n-type semiconductor layer 12. Herein, the light receiving surface sides of the four comer portions 18, 19, 20 and 21 of the crystal substrate 11 are clamped and held with four holders 26, 27,28 and 29 (see FIG. 2). In place of the four holders 26, 27,28 and 29, one holder may also be adopted.

The locations corresponding to four corner portions 18, 19, 20, and 21 of the crystal substrate 11, which are behind the retainers 26, 27, 28, and 29, are non-film formation areas 30, 31, 32, and 33 where the n-type semiconductor layer 12 is not formed. Note that the retainer 29 as one of four retainers is provided with an identifying hole, and the n-type semiconductor layer 12 is formed at a location corresponding to the identifying hole to be an identifying mark 34.The identification mark 34 can be omitted.

Since other than the above areas is not behind the retainers 26, 27, 28, and 29, the n-type semiconductor layer 12 is formed to be wrap around continuously from the light receiving surface of the crystal substrate 11 to the side surfaces. FIG. 1(b) shows wrapping around n-type semiconductor layers 35, 36, 37, and 38 which are formed on the side surfaces of the crystal substrate 11.

The p-type semiconductor layer 13 is formed on the whole rear surface of the crystal substrate 11, except for the areas corresponding to the four corner portions 18, 19, 20 and 21 of the outer edge of the crystal substrate 11. The crystal substrate 11 is retained at a predetermined position in a plasma CVD apparatus in order to form the p-type semiconductor layer 13, and here it is assumed that four retainers 26, 27, 28, and 29 used in forming the n-type semiconductor layer 12 are directly used to hold the rear surface side of the crystal substrate 11 at four corner portions 18, 19, 20, and 21. The locations corresponding to four corner portions 18, 19, 20, and 21 of the crystal substrate 11, which are behind the retainers 26, 27, 28, and 29, are non-film formation areas 39, 40, 41, and 42 where the p-type semiconductor layer 13 is not formed. Note that an identifying mark 43 is formed by way of the p-type semiconductor layer 13 corresponding to the identifying hole provided to the retainer 29. The identification mark 43 can be omitted.

Since other than the above areas is not behind the retainers, the p-type semiconductor layer 13 is formed to be wrap around continuously from the rear surface of the crystal substrate 11 to the side surfaces. FIG. 1(c) shows wrapping around p-type semiconductor layers 44, 45,46, and 47 which are formed on the side surfaces of the crystal substrate 11.

When the non-film formation areas 39, 40, 41, and 42 in the p-type semiconductor layer 13 and the non-film formation areas 30, 31, 32, and 33 in the n-type semiconductor layer 12 are distinguished, the latter are each called a first non-film formation area and the former are each called a second non-film formation area.

As shown in FIGs. 1(b) and 1(c), the non-film formation areas 30, 31, 32, and 33 in the n-type semiconductor layer 12 and the non-film formation areas 39, 40, 41, and 42 in the p-type semiconductor layer 13 respectively are to have an up-and-down inverse relationship with respect to the crystal substrate 11 in a case of no manufacturing error.

On the other hand, there are formed, on the side surfaces of the crystal substrate 11, the wrapping around n-type semiconductor layers 35, 36, 37, and 38 from the light receiving surface side, and the wrapping around p-type semiconductor layers 44, 45, 46, and 47 from the rear surface side. Therefore, there are formed, on the side surfaces of the crystal substrate 11, an overlapping layer where the wrapping around n-type semiconductor layer 35 and the wrapping around p-type semiconductor layer 44 overlap each other, an overlapping layer where the wrapping around n-type semiconductor layer 36 and the wrapping around p-type semiconductor layer 45 overlap each other, an overlapping layer where the wrapping around n-type semiconductor layer 37 and the wrapping around p-type semiconductor layer 46 overlap each other, and an overlapping layer where the wrapping around n-type semiconductor layer 38 and the wrapping around p-type semiconductor layer 47 overlap each other. FIG. 1(a) shows an overlapping layer 48 where the wrapping around n-type semiconductor layer 36 and the wrapping around p-type semiconductor layer 45 overlap each other, and an overlapping layer 49 where the wrapping around n-type semiconductor layer 38 and the wrapping around p-type semiconductor layer 47 overlap each other. According to an experimental result, it was found that formation of these overlapping layers has no effect on leakage.

The transparent conductive film 14 on the light receiving surface side is to be laminated on a first semiconductor layer over one main surface of the crystal substrate 11, and here, the transparent conductive film 14 on the light receiving surface side is laminated on the n-type semiconductor layer 12 or the n-type amorphous silicon layer 23 in the light receiving surface of the crystal substrate 11. The transparent conductive film 15 on the rear surface side, which is to be laminated on a second semiconductor layer over the other main surface of the crystal substrate 11, is laminated, here, on the type semiconductor layer 13 or the p-type amorphous silicon layer 25 on the rear surface of the crystal substrate 11. When the transparent conductive film 14 on the light receiving surface side and the transparent conductive film 15 on the rear surface side are distinguished, the former is called a first transparent conductive film and the latter is called a second conductive film.

As shown in FIG. 1(c), the transparent conductive film 14 on the light receiving surface side is disposed on the inside by an appropriate dimension from the outer edge of the crystal substrate 11. The dimension concerned is set at the minimum value within a limit not to coincide with the outer shape of the crystal substrate 11 inclusive of overall errors in the production. Specifically, the transparent conductive film 14 is disposed independently of the non-film-formed areas 30, 31, 32 and 33 of the n-type semiconductor layer 12. Accordingly, when the non-film-formed areas 30, 31, 32 and 33 are wide, the transparent conductive film 14 is disposed on the non-film-formed areas 30, 31, 32 and 33. In the example of FIG. 1(b), the transparent conductive film 14 is disposed on the non-film-formed areas 32 and 33. On the other hand, the transparent conductive film 15 on the rear surface side is of the same plan shape as the crystal substrate 11. In other words, the transparent conductive film 15 is formed over the whole rear surface of the crystal substrate 11.

Such transparent conductive films 14 and 15 are each a thin layer (TCO layer) constituted by including at least one of the metal oxides having a polycrystalline structure such as indium oxide (In₂O₃), zinc oxide (ZnO), tin oxide (SnO₂) and titanium oxide (TiO₂), and functions as a light-transmitting electrode section. In these metal oxides, dopants such as tin (Sn), zinc (Zn), tungsten (W), antimony (Sb), titanium (Ti), aluminum(Al), cerium (Ce) and gallium (Ga) may also be included. The concentration of the dopant can be 0 to 20% by mass. The thickness of each of the transparent conductive films 14 and 15 is, for example, about 50 nm to about 200 nm. The transparent conductive films 14 and 15 can be formed by using a sputtering apparatus.

FIG. 2 is a diagram showing the crystal substrate 11, the n-type semiconductor layer 12 and the p-type semiconductor layer 13 of the structure of the solar cell 10. FIG. 2(a) is an enlarged sectional view of the side surface of the crystal substrate 11, FIG. 2(b) is an enlarged sectional view of the overlapping layer 49, and FIG. 2(c) is a diagram showing the thickness distributions of the n-type semiconductor layer 12 and the p-type semiconductor layer 13, on the side surface of the crystal substrate 11. It may be noted that herein, the diagrammatic representation of the texture structure on the surface of the crystal substrate 11 is omitted. The effect of the texture structure on the thickness distributions of the n-type semiconductor layer 12 and the p-type semiconductor layer 13 is described with reference to following FIG. 3, and accordingly the effect of the texture structure on the thickness distributions is not taken into account.

The n-type semiconductor layer 12 is formed as a film in the direction from the light receiving surface side of the crystal substrate 11, and thus also formed as a film so as to wrap around the side face of the crystal substrate 11. Such a wrapping around portion is the wrapping around n-type semiconductor layer 38. The thickness tₙ of the wrapping around portion is thickest on the light receiving surface side of the side surface of the crystal substrate 11, and gradually becomes thinner toward the rear surface side. When the thickness of the n-type semiconductor layer 12 formed as a film on the light receiving surface is represented by tₙ₀, the thickness tₙ of the wrapping around n-type semiconductor layer 38 on the light receiving surface side on the side surface of the crystal substrate 11 is nearly tₙ₀ at the end of the light receiving surface, and nearly zero (0) at the end of the rear surface, as shown in FIG. 2(c).

The p-type semiconductor layer 13 is formed by the film formation in the direction from the rear surface side of the crystal substrate 11, and thus also formed so as to wrap around the side face of the crystal substrate 11. Such a wrapping around portion is the wrapping around p-type semiconductor layer 47. The thickness tₚ of the wrapping around portion is thickest on the rear surface side of the side surface of the crystal substrate 11, and gradually becomes thinner toward the light receiving surface side. When the thickness of the p-type semiconductor layer 13 formed as a film on the light receiving surface is represented by tₚ₀, the thickness tₚ of the wrapping around p-type semiconductor layer 47 on the rear surface side on the side surface of the crystal substrate 11 is nearly tₚ₀ at the end of the rear surface, and nearly zero (0) at the end of the light receiving surface, as shown in FIG. 2(c).

Both of the n-type semiconductor layer 12 and the p-type semiconductor layer 13 wrap around the side surface of the crystal substrate 11, and accordingly the total thickness of the wrapping around semiconductor layers is (the thickness tₙ of the wrapping around n-type semiconductor layer 38 + the thickness tₚ of the wrapping around p-type semiconductor layer 47). In FIG. 2(c), the distribution of (tₙ + tₚ) along the side surface of the crystal substrate 11 is shown.

The thickness tₙ of the n-type semiconductor layer 38 on the side surface is slightly less than tₙ₀ at the end of the light receiving surface, and the thickness tp of the wrapping around p-type semiconductor layer 47 is slightly less than tₚ₀ at the end of the rear surface. Accordingly, the thickness tₙ of the wrapping around n-type semiconductor layer 38 on the side surface is less than tₙ₀, and the thickness tₚ of the wrapping around p-type semiconductor layer 47 is less than tₚ₀. In addition, the total thickness (tₙ + tₚ) of the wrapping around semiconductor layers is more than either of tₙ₀ and tₚ₀, but is less than (tₙ₀ + tₚ₀). Thus, the side surface of the crystal substrate 11 is covered with the wrapping around semiconductor layers, and the crystal substrate 11 is not exposed.

For example, when tₙ₀ and tₚ₀ are each set to be about 20 nm, the side surface of the crystal substrate 11 is covered with semiconductor layers having the thickness falling within a range from about 20 to 40 nm. This thickness is not too thin, not too thick, but is an appropriate thickness from the viewpoint of the protection of the side surface of the crystal substrate 11. In other words, the wrapping around semiconductor layers can be used, as they are, as the protective films for the side surface of the crystal substrate 11.

FIG. 3 corresponds to FIG. 2, and is a diagram taking into consideration the texture structure 50 formed on the surface of the crystal substrate 11. FIG. 3(a) is an enlarged sectional view of the side surface of the crystal substrate 11, FIG. 3(b) is a diagram showing the texture structure 50, and FIG. 3(c) is a diagram showing the thickness distributions of the n-type semiconductor layer 12 and the p-type semiconductor layer 13, on the side surface of the crystal substrate 11. It may be noted that the n-type semiconductor layer 12 has a laminated structure composed of the i-type amorphous silicon layer 22 and an n-type amorphous silicon layer 23, and the p-type semiconductor layer 13 has a laminated structure composed of an i-type amorphous silicon layer 24 and a p-type amorphous silicon layer 25, but in FIG. 3, a diagrammatic representation of these laminated structures is omitted.

The texture structure 50 is a fine uneven pattern formed on the surface of the crystal substrate 11 by treating the crystal substrate 11 with an anisotropic etching solution such as a KOH solution. As shown in FIG. 3(b), the protrusions each have a quadrilateral pyramid shape. The extension direction of an edge of the base of the quadrilateral pyramid is parallel to the Y-direction of the crystal substrate 11, or parallel to the direction perpendicular to the Y-direction. This is also the case on the side surface of the crystal substrate 11. An example of the dimensions of a quadrilateral pyramid is such that the length of an edge of the base of the quadrilateral pyramid is about 2 to 5 µm, the angle between the base and the slant face of the quadrilateral pyramid is 60 degrees, and the vertical height of the vertex with reference to the base of the quadrilateral pyramid is (3^{0.5}) times the length of the edge of the base.

The texture structure 50 has slant faces each inclined at a certain angle to the surface of the crystal substrate 11, and hence the n-type semiconductor layer 12 and the p-type semiconductor layer 13 are formed on these slant faces. Accordingly, the thickness values tₙ and tₚ of these layers are defined as the values obtained by measuring along the normal line directions of the slant faces of the texture structure 50.

The n-type semiconductor layer 12 is formed as a film in the direction from the light receiving surface side of the crystal substrate 11, and thus also formed as a film so as to wrap around the side face of the crystal substrate 11. The texture structure 50 has quadrilateral pyramid shapes, and hence the n-type semiconductor layer 12 is formed so as to cover all the quadrilateral pyramid shaped faces on the light receiving surface of the crystal substrate 11. On the side surface of the crystal substrate 11, of the four slant faces of each of the quadrilateral pyramid shapes of the texture structure 50, one slant face faces the light receiving surface side, another slant face faces the rear surface side, and the remaining two slant faces face in the intermediate directions between these directions. Accordingly, the n-type semiconductor layer 12 is formed on the faces facing the light receiving surface side of the texture structure 50, but is not formed on the faces facing the rear surface side of the texture structure 50.

Similarly, the p-type semiconductor layer 13 is formed as a film in the direction from the rear surface side of the crystal substrate 11, and thus also formed as a film so as to wrap around the side face of the crystal substrate 11. The texture structure 50 has quadrilateral pyramid shapes, and hence the p-type semiconductor layer 13 is formed so as to cover all the quadrilateral pyramid shaped faces on the rear surface of the crystal substrate 11. On the side surface of the crystal substrate 11, of the four slant faces of each of the quadrilateral pyramid shapes of the texture structure 50, one slant face faces the rear surface side, another slant face faces the light receiving surface side, and the remaining two slant faces face in the intermediate directions between these directions. Accordingly, the p-type semiconductor layer 13 is formed on the faces facing the rear surface side of the texture structure 50, but is not formed on the faces facing the light receiving surface side of the texture structure 50.

In FIG. 3(b), the region 51 in which the n-type semiconductor layer 12 is formed and the region 52 in which the p-type semiconductor layer 13 is formed in the texture structure 50 on the side surface of the crystal substrate 11 are shown. In this way, on the side surface of the crystal substrate 11, the texture structure 50 is divided into two regions, namely, the region 51 in which the n-type semiconductor layer 12 is formed and the region 52 in which the p-type semiconductor layer 13 is formed. For the purpose of distinguishing these two regions from each other, hereinafter, the region 51 is referred to as the first region 51, and the region 52 is referred to as the second region 52.

In the same manner as in the foregoing description for FIG. 2, the thickness tₙ of the wrapping around n-type semiconductor layer 38 wrapping around the side surface of the crystal substrate 11, said thickness being in the normal line direction of the n-type semiconductor layer, is thickest on the light receiving surface side of the side surface of the crystal substrate 11, and gradually becomes thinner toward the rear surface side. When the thickness of the n-type semiconductor layer 12 formed as a film on the light receiving surface, said thickness being in the normal line direction of the n-type semiconductor layer, is represented by tₙ₀, the thickness tₙ of the wrapping around n-type semiconductor layer 38 on the side surface of the crystal substrate 11, said thickness being in the normal line direction of the n-type semiconductor layer, is nearly tₙ₀ at the end of the light receiving surface, and nearly zero (0) at the end of the rear surface, as shown in FIG. 3(c).

In addition, the thickness tₚ of the wrapping around p-type semiconductor layer 47 wrapping around the side surface of the crystal substrate 11, said thickness being in the normal line direction of the p-type semiconductor layer, is thickest on the rear surface side of the side surface of the crystal substrate 11, and gradually becomes thinner toward the light receiving surface side. When the thickness of the p-type semiconductor layer 13 formed as a film on the light receiving surface, said thickness being in the normal line direction of the p-type semiconductor layer, is represented by tₚ₀, the thickness tₚ of the wrapping around p-type semiconductor layer 47 from the rear surface side, on the side surface of the crystal substrate 11 is nearly tₚ₀ at the end of the rear surface, and nearly zero (0) at the end of the light receiving surface, as shown in FIG. 3(c).

Both of the n-type semiconductor layer 12 and the p-type semiconductor layer 13 wrap around the side surface of the crystal substrate 11. However, the wrapping around n-type semiconductor layer 38 is not formed in the region 2 of the texture structure 50, and the wrapping around p-type semiconductor layer 47 is not formed in the region 1 of the texture structure 50. In FIG. 3(c), the thickness distributions of the wrapping around semiconductor layers along the side surface of the crystal substrate 11 are shown. As shown in this figure, on the side surface of the crystal substrate 11, from the end of the light receiving surface toward the end of the rear surface, the first region 51 in which the n-type semiconductor layer 12 is formed and the second region 52 in which the p-type semiconductor layer 13 is formed are alternately repeated.

On the side surface, the thickness tₙ of the wrapping around n-type semiconductor layer 38, said thickness being in the normal line direction of the n-type semiconductor layer, is slightly less than tₙ₀ at the end of the light receiving surface, and the thickness tₚ of the wrapping around p-type semiconductor layer 47, said thickness being in the normal line direction of the p-type semiconductor layer, is slightly less than tₚ₀ at the end of the rear surface. Accordingly, the thickness tₙ of the wrapping around n-type semiconductor layer 38 on the side surface, said thickness being in the normal line direction of the n-type semiconductor layer, is less than tₙ₀, and the thickness tₚ of the wrapping around p-type semiconductor layer 47 on the side surface, said thickness being in the normal line direction of the p-type semiconductor layer, is less than tₚ₀. In addition, the total value (tₙ + tₚ) of the thickness values of the semiconductor layers formed so as to wrap around one texture structure 50, said thickness being in the normal line direction of the semiconductor layers, is more than tₙ₀ and more than tₚ₀, but is less than (tₙ₀ + tₚ₀). Thus, the side surface of the crystal substrate 11 is covered with the wrapping around semiconductor layers, and the crystal substrate 11 is not exposed.

For example, when tₙ₀ and tₚ₀ are each set to be about 20 nm, on the side surface of the crystal substrate 11, the total value of the thickness values of the semiconductor layers formed so as to wrap around one texture structure 50, said thickness being in the normal line direction of the semiconductor layers, falls within a range from about 20 to 40 nm, and the side surface of the substrate 11 is covered with the semiconductor layers having a total thickness falling within the range from about 20 to 40 nm. This thickness is not too thin, not too thick, but is an appropriate thickness from the viewpoint of the protection of the side surface of the crystal substrate 11. In other words, the wrapping around semiconductor layers can be used, as they are, as the protective films for the side surface of the crystal substrate 11.

In the foregoing description, there is shown, as an example, a photoelectric conversion section having a structure in which an amorphous silicon thin layer is laminated on each of both surfaces of the crystal substrate 11. However, the photoelectric conversion section is not limited to the shown photoelectric conversion section. The photoelectric conversion section may have, for example, a structure having no i-type amorphous silicon layer, no n-type amorphous silicon layer, or no p-type amorphous silicon layer, or a structure using a semiconductor (for example, gallium arsenide) other than silicon. It may be noted that examples of the amorphous silicon in the present embodiment include crystalline particle-containing amorphous silicon.

In addition, in the description presented above, the one conductivity type is taken as the n-type and the other conductivity type is taken as the p-type. However, conversely, the one conductivity type may be taken as the p-type and the other conductivity type may be taken as the n-type. In addition, the one main surface is taken as the light receiving surface, and the other main surface is taken as the rear surface. However, conversely, the one main surface may be taken as the rear surface, and the other main surface may be taken as the light receiving surface.

In addition, the shape of the crystal substrate is taken as an octagon shape formed by cutting out the four corner portions. However, the shape of the crystal substrate may be a rectangular shape with which the four corner portions are not cut out, a polygon other than an octagon, or a shape other than a rectangular shape such as a round shape or an elliptical shape.

In addition, in the foregoing embodiment, a constitution is adopted in which the four corner portions 18, 19, 20 and 21 of the crystal substrate 11 are held. However, a constitution is also satisfactory in which at least one position of the crystal substrate 11 is held, and for example a constitution allowing the corner portions 18 and 19 of the crystal substrate 11 to be held may also be adopted.

### REFERENCE SIGNS LIST

10 solar cell, 11 crystal substrate, 12 n-type semiconductor layer, 13 p-type semiconductor layer, 14,15 transparent conductive film, 16,17 current collecting electrode, 18,19,20,21 corner portion, 22,24 i-type amorphous silicon layer, 23 n-type amorphous silicon layer, 25 p-type amorphous silicon layer, 26,27,28,29 holder, 30,31,32,33,39,40,41,42 non-film-formed area, 34,43 identification mark, 35,36,37,38 wrapping around n-type semiconductor layer, 44,45,46,47 wrapping around p-type semiconductor layer, 48,49 overlapping layer, 50 texture structure, 51 (First) region, 52 (second) region

## Claims

1. A solar cell comprising:
a crystal substrate having one conductivity type;
a first semiconductor layer having the one conductivity type, formed on one main surface of the crystal substrate; and
a second semiconductor layer having another conductivity type, formed on another main surface of the crystal substrate,
wherein the first semiconductor layer and the second semiconductor layer cover a part of a side surface intersecting the main surfaces of the crystal substrate, the thickness of the first semiconductor layer on the side surface, said thickness being in the normal line direction of the first semiconductor layer, is less than the thickness of the first semiconductor layer on the one main surface, said thickness being in the normal line direction of the first semiconductor layer, and the thickness of the second semiconductor layer on the side surface, said thickness being in the normal line direction of the second semiconductor layer, is less than the thickness of the second semiconductor layer on the other main surface, said thickness being in the normal line direction of the second semiconductor layer.

2. The solar cell according to claim 1, wherein at least one of the first semiconductor layer and the second semiconductor layer is an amorphous semiconductor layer.

3. The solar cell according to claim 1 or 2, wherein an i-type amorphous semiconductor layer is formed at least between the first semiconductor layer and the crystal substrate or between the second semiconductor layer and the crystal substrate.

4. The solar cell according to any one of claims 1 to 3, wherein the one conductivity type is an n-type and the other conductivity type is a p-type.

5. The solar cell according to any one of claims 1 to 4, further comprising a first region of the one conductivity type and a second region of the other conductivity type on the side surface.

6. The solar cell according to claim 5, wherein the crystal substrate includes a texture structure having a plurality of asperities on the one main surface, the other main surface and the side surface; and
the first region and the second region, partitioned according to the uneven shape of the texture structure, are formed on the side surface.

7. The solar cell according to any one of claims 1 to 6, wherein on the side surface, the first semiconductor layer and the second semiconductor layer are superposed on each other and the crystal substrate is not exposed.

8. A solar cell, wherein on the side surface, the thickness of the layer formed by the superposition of the first semiconductor layer and the second semiconductor layer, said thickness being in the normal line direction of the layer, is more than any of the thickness of the first semiconductor layer on the one main surface, said thickness being in the normal line direction of the first semiconductor layer, and the thickness of the second semiconductor layer on the other main surface, said thickness being in the normal line direction of the second semiconductor layer, and less than the value obtained by summing the thickness of the first semiconductor layer on the one main surface, said thickness being in the normal line direction of the first semiconductor layer, and the thickness of the second semiconductor layer on the other main surface, said thickness being in the normal line direction of the second semiconductor layer.
